# EUROPÄISCHE PATENTSCHRIFT

(11) **EP 3 074 819 B1**
(45) Veröffentlichungstag und Bekanntmachung des Hinweises auf die Patenterteilung: **12.04.2023**
(21) Anmeldenummer: 13798336.7
(22) Anmeldetag: 29.11.2013
(51) Int. Cl.: G03F 7/00

(54) **STEMPEL MIT EINER STEMPELSTRUKTUR SOWIE VERFAHREN ZU DESSEN HERSTELLUNG**
MOULD WITH A MOULD PATTERN, AND METHOD FOR PRODUCING SAME
TIMBRE POURVU D'UNE STRUCTURE ET PROCÉDÉ POUR SA FABRICATION

(43) Veröffentlichungstag der Anmeldung: 05.10.2016
(73) Patentinhaber: EV Group E. Thallner GmbH, 4782 St. Florian am Inn (AT)
(72) Erfinder: CHOUIKI, Mustapha, 4020 Linz (AT)
(74) Vertreter: Schneider, Sascha
(86) Internationale Anmeldenummer: PCT/EP2013/075113
(87) Internationale Veröffentlichungsnummer: WO 2015/078520

(56) Entgegenhaltungen:
- EP-A1- 1 193 056
- JP-A- 2005 342 927
- US-A1- 2004 086 709
- US-A1- 2008 230 773
- CHOI K M ET AL: "A PHOTOCURABLE POLY(DIMETHYLSILOXANE) CHEMISTRY DESIGNED FOR SOFT LITHOGRAPHIC MOLDING AND PRINTING IN THE NANOMETER REGIME", JOURNAL OF THE AMERICAN CHEMICAL SOCIETY, ACS PUBLICATIONS, US, Bd. 125, 1. Januar 2003 (2003-01-01), Seiten 4060-4061, XP002323413, ISSN: 0002-7863, DOI: 10.1021/JA029973K
- SCHWINGER W ET AL: "Fabrication of nano-gold islands with mum spacing using 2.5 dimensional PDMS stamps", MICROELECTRONIC ENGINEERING, ELSEVIER PUBLISHERS BV., AMSTERDAM, NL, Bd. 85, Nr. 5-6, 1. Mai 2008 (2008-05-01), Seiten 1346-1349, XP022678744, ISSN: 0167-9317, DOI: 10.1016/J.MEE.2008.01.039 [gefunden am 2008-01-26]
- SCHMID H ET AL: "Siloxane polymers for high-resolution, high-accuracy soft lithography", MACROMOLECULES, AMERICAN CHEMICAL SOCIETY, US, Bd. 33, Nr. 8, 25. März 2000 (2000-03-25), Seiten 3042-3049, XP002385970, ISSN: 0024-9297, DOI: 10.1021/MA982034L
- XIA Y ET AL: "SOFT LITHOGRAPHY", ANNUAL REVIEW OF MATERIALS SCIENCE, ANNUAL REVIEWS INC., PALO ALTO, CA, US, Bd. 28, 1. Januar 1998 (1998-01-01), Seiten 153-184, XP009023786, ISSN: 0084-6600, DOI: 10.1146/ANNUREV.MATSCI.28.1.153

## Beschreibung

Die Erfindung betrifft ein System bestehend aus einer Prägemasse und einem Imprintstempel sowie ein Verfahren zur Ausbildung eines solchen Systems.

In der Halbleiterindustrie müssen Strukturierungsprozesse an Materialien durchgeführt werden um entsprechende funktionale Elemente erzeugen zu können. Einer der wichtigsten Strukturierungsprozesse der letzten Jahrzehnte ist bis heute noch die Photolithographie.

In den letzten Jahren hat sich allerdings neben der Photolithographie die Imprinttechnologie als neue, alternative Strukturierungstechnologie durchgesetzt, die nicht ausschließlich, aber momentan noch vorwiegend, zur Strukturierung hochsymmetrischer, vor allem repetitiver, Strukturelemente dient. Mit Hilfe der Imprinttechnologie können Oberflächenstrukturen in eine Prägemasse direkt durch einen Stempelprozess erstellt werden. Die dadurch entstehenden Vorteile sind offensichtlich. Man kann auf Chemikalien zur Entwicklung und Ätzung verzichten, die für einen photolithographischen Prozess noch nötig waren. Des Weiteren können heute bereits Strukturgrößen im Nanometerbereich geprägt werden, deren Herstellung mit der gewöhnlichen Photolithographie nur durch äußerst komplizierte und vor allem teure Anlagen denkbar wäre. CHOI KM ET AL: offenbaren in "A PHOTOCURABLE POLY(DIMETHYLSILOXANE) CHEMISTRY DESIGNED FOR SOFT LITHOGRAPHIC MOLDING AND PRINTING IN THE NANOMETER REGIME", JOURNAL OF THE AMERICAN CHEMICAL SOCIETY, ACS PUBLICATIONS, US, Bd. 125, 1. Januar 2003 (2003-01-01), Seiten 4060-4061, XP002323413, ISSN: 0002-7863, DOI: 10.1021/:tA029973K ein Material für die Softlithographie. EP 1193056 A1 offenbart einen Stempel aus Silikonelastomer. US 2004/086709 A1 offenbart ein Verfahren zur Übertragung einer gemusterten polyelektrolyt-Mehrschicht. US 2008/230773 A1 offenbart Verfahren zur Strukturierung von Substraten. SCHWINGER W ET AL offenbaren in: "Fabrication of nano-gold islands with mum spacing using 2.5 dimensional PDMS stamps", MICROELECTRONIC ENGINEERING, ELSEVIER PUBLISHERS BV., AMSTERDAM, NL, Bd. 85, Nr. 5-6, 1. Mai 2008 (2008-05-01), Seiten 1346-1349, XP0226787 44, ISSN: 0167-9317, DOI: 10.1016/J.MEE.2008.01 .039 ein Verfahren, welches 2.5 dimensionale PDMS Stempel verwendet. SCHMID H ET AL offenbaren in: "Siloxane polymers for high-resolution, high accuracy soft lithography", MACROMOLECULES, AMERICAN CHEMICAL SOCIETY, US, Bd. 33, Nr. 8, 25. März 2000 (2000-03-25), Seiten 3042-3049, XP002385970, ISSN: 0024-9297, DOI: 10.1021 1MA982034L ein Polymer für die Softlithografie. XIA Y ET AL offenbaren in: "SOFT LITHOGRAPHY", ANNUAL REVIEW OF MATERIALS SCIENCE, ANNUAL REVIEWS INC., PALO AL TO, CA, US, Bd. 28, 1. Januar 1998 (1998-01-01), Seiten 153-184, XP009023786, ISSN: 0084-6600, DOI: 10.1146/ANNUREV.MATSC1.28.1.153 Material für die Softlithografie. JP 2005 342927 A offenbart ein plastisches Muster für ein Harzmaterial.

In der Imprinttechnologie unterscheidet man zwischen zwei Arten von Stempeln, den Hartstempeln und den Weichstempeln. Jeder Stempelprozess kann theoretisch mit einem Hartstempel oder einem Weichstempel durchgeführt werden. Es gibt aber mehrere technische und finanzielle Gründe, den Hartstempel selbst nur als sogenannten Masterstempel zu verwenden, und aus diesem Masterstempel, wann immer nötig, einen Weichstempel abzuformen, der dann als eigentlicher Strukturstempel verwendet wird. Der Hartstempel ist also ein Negativ des Weichstempels. Der Hartstempel wird nur für die Herstellung mehrerer Weichstempel benötigt. Weichstempel können durch unterschiedliche chemische, physikalische und technische Parameter von Hartstempel unterschieden werden. Denkbar wäre eine Unterscheidung aufgrund des Elastizitätsverhaltens. Weichstempel besitzen ein vorwiegend auf Entropieelastizität, Hartstempel vorwiegend auf Energieelastizität, beruhendes Verformungsverhalten. Des Weiteren können die beiden Stempelarten beispielsweise über ihre Härte unterschieden werden. Die Härte ist der Widerstand, den ein Material einem eindringenden Körper entgegenstellt. Da Hartstempel vorwiegend aus Metallen oder Keramiken bestehen, besitzen sie entsprechend hohe Härtewerte. Es gibt unterschiedliche Möglichkeiten die Härte eines Festkörpers anzugeben. Eine sehr gebräuchliche Methode ist die Angabe der Härte nach Vickers. Ohne auf Einzelheiten einzugehen kann man grob sagen, dass Hartstempel Vickershärten jenseits von 500 HV besitzen werden.

Hartstempel haben zwar den Vorteil, dass sie durch geeignete Prozesse wie Elektronenstrahllithographie oder Laserstrahllithographie aus einem Bauteil eines Materials mit hoher Festigkeit und hoher Steifigkeit direkt gefertigt werden können. Derartige Hartstempel besitzen eine sehr hohe Härte und sind damit mehr oder weniger verschleißfest. Der hohen Festigkeit und Verschleißfestigkeit stehen allerdings vor allem die hohen Kosten gegenüber, die für die Herstellung eines solchen Hartstempel anfallen. Selbst wenn der Hartstempel für hunderte von Prägeschritten genutzt werden kann, wird auch er mit der Zeit einen nicht mehr zu vernachlässigende Verschleiß aufweisen. Des Weiteren ist die Entformung des Hartstempels von der Prägemasse technisch schwierig. Hartstempel besitzen einen relativ hohen Biegewiderstand. Sie sind nicht besonders gut verformbar, müssen also in Normalenrichtung zur Prägeoberfläche abgehoben werden. Bei der Entformung der Hartstempel nach dem Prägeprozess kann es dabei regelmäßig zu einer Zerstörung der geprägten Nano- und/oder Mikrostrukturen kommen, da der Hartstempel eine sehr hohe Steifigkeit besitzt und daher die Mikro- und/oder Nanostrukturen der gerade abgeformten Prägemasse zerstören kann. Des Weiteren können Substrate Defekte aufweisen, die in weiterer Folge zur Beschädigung bzw. Zerstörung des Hartstempels führen können. Wird der Hartstempel allerdings nur als Masterstempel verwendet, ist der Abformprozess des Weichstempels aus dem Masterstempel sehr gut kontrollierbar und mit sehr wenig Verschleiß des Masterstempels verbunden.

Weichstempel lassen sich sehr einfach durch Replikationsprozesse aus dem Masterstempel (Hartstempel) fertigen. Der Masterstempel stellt dabei das zum Weichstempel entsprechende Negativ dar. Die Weichstempel werden also auf dem Masterstempel geprägt, danach entformt und dann als Strukturstempel zum Prägen der Stempelstrukturen in einer Prägemasse, die meistens auf einem Substrat aufgebracht wird, verwendet. Weichstempel lassen sich mechanisch viel einfacher, schonender und unproblematischer von der Prägemasse entfernen als Hartstempel. Des Weiteren können beliebig viele Weichstempel von einem Masterstempel abgeformt werden. Nachdem ein Weichstempel einen gewissen Verschleiß ausweist, verwirft man den Weichstempel und formt einen neuen Weichstempel aus dem Masterstempel.

Das Problem mit dem heutigen Stand der Technik besteht darin, dass vor allem Weichstempel aufgrund ihres chemischen Aufbaus eine sehr hohe Saugfähigkeit für andere molekulare Verbindungen besitzen. Sie sind also im Allgemeinen für andere molekulare Verbindungen permeabel, im Gegensatz zu Hartstempeln, die vorwiegend aus Metallen, Keramiken oder Gläsern bestehen. Bei metallischen und keramischen Mikrostrukturen ist eine Aufnahme von molekularen Substanzen in den meisten Fällen ausgeschlossen, dennoch kann es auch bei speziellen Hartstempeln zu einem Aufsaugen der molekularen Substanzen kommen.

Weichstempel absorbieren während des Prägeprozesses mit der Prägemasse häufig einen Teil der Prägemasse. Die Absorption führt zu mehreren unerwünschten Effekten.

Erstens kommt es, durch die Aufnahme der Moleküle der Prägemasse, zu einer Aufschwellung des Weichstempels. Die Aufschwellung ist vor allem im Bereich der Mikro- und/oder Nanostrukturen an der Oberfläche des Weichstempels problematisch, da bereits geringe Mengen der Moleküle der Prägemasse ausreichen, die Mikro- und/oder Nanostrukturen zu verzerren. Da ein Weichstempel mehrfach verwendet wird, saugt er im Laufe seiner Verwendung immer mehr Prägemassemoleküle auf. Die Aufnahme der Prägemassemoleküle reduziert die Standzeit der Weichstempel entscheidend. Die Schwellung ist entweder direkt mittels unterschiedlicher Sonden wie beispielsweise der Atomic Force Mikroskopie (AFM), der Rasterelektronenmikroskopie (REM) etc. messbar, oder indirekt über Volumen und/oder Gewichtszunahme. Die Messung der Volumen- und/oder Gewichtszunahme erfordert allerdings Messgeräte mit sehr hohen Auflösungen. Denkbar wäre beispielsweise die Messung der Massenzunahme durch Mikro- und/oder Nanogravimetrische Methoden.

Des Weiteren werden die Prägemassen entweder thermisch oder mittels elektromagnetischer Strahlung gehärtet. Vor allem bei der Härtung durch elektromagnetische Strahlung wirken sich die bereits teilweise in den Stempel eingedrungenen Prägemassemoleküle negativ auf die Belichtungszeit der gesamten Prägemasse aus. Der Grund hierfür liegt in der Aushärtung der in den Weichstempel eingedrungenen Prägemassemoleküle. Die Prägemassemoleküle im Weichstempel werden ausgehärtet, werden damit weniger transparent und reduzieren damit die Intensität der, zur eigentlichen Prägemasse vordringenden, elektromagnetischen Strahlung. Dieses Problem ist für Weichstempel und Hartstempel gleichermaßen von Bedeutung.

Ein drittes Problem stellt die Adhäsion des Weichstempels dar. Weichstempel bestehen vorwiegend aus Polymeren, die eine ähnliche physikalische und/oder chemische Eigenschaft besitzen wie die Prägemasse. Daher kommt es zu einer Adhäsion der Oberfläche des Weichstempels mit der Prägemasse, die sich negativ auf die Entformungseigenschaft des Weichstempels auswirkt.

Aufgabe der vorliegenden Erfindung ist es daher, die Herstellung von Strukturstempeln für die Imprinttechnologie derart zu verbessern, dass ein optimales Stempelmaterial offenbart wird.

Diese Aufgabe wird mit den Merkmalen der unabhängigen Ansprüche 1 und 6 gelöst. Vorteilhafte Weiterbildungen der Erfindung sind in den Unteransprüchen angegeben.

Die Erfindung handelt von einem Stempel, mit Vorzug einem Weichstempel, welcher aus einem Stempelmaterial besteht, das eine möglichst einfache Entformung des Stempels von der Prägemasse erlaubt, möglichst keine Aufschwellung besitzt und der durch die eigentliche Prägemasse nicht verunreinigt wird. Das Stempelmaterial ist demnach erfindungsgemäß insbesondere impermeabel gegenüber der Prägemasse. Es ist im Allgemeinen von besonderem erfindungsgemäßen Vorteil, wenn sich Hydrophilität und Hydrophobizität zwischen Prägemasse und dem Stempelmaterial des erfindungsgemäßem Strukturstempel abwechseln. Ist die Prägemasse hydrophob, so sollte das Stempelmaterial des erfindungsgemäßen Strukturstempels hydrophil sein und umgekehrt. In ganz besonderen Fällen kann es allerdings von besonderem Vorteil sein, wenn Strukturstempel und Prägemasse beide hydrophob bzw. beide hydrophil sind. Durch die Möglichkeit, das erfindungsgemäße Stempelmaterial des Strukturstempels auszuwählen, kann immer ein Material gewählt werden, welches diese geringen Adhäsionseigenschaften in Bezug auf die Prägemasse besitzt. Des Weiteren ist es daher von erfindungsgemäßem Vorteil, wenn das erfindungsgemäße Stempelmaterial impermeabel für die Moleküle der Prägemasse ist. Ein weiterer erfindungsmäßiger Vorteil ist die, insbesondere gezielt einstellbare, Oberfläche des erfindungsgemäßen Stempelmaterials. Vor allem bei einem Weichstempel, dessen Oberfläche extrem hohe Rauigkeiten aufweist, würde sich das negativ auf die zu prägende Struktur auswirken. Durch die Verwendung eines erfindungsgemäßen Stempelmaterials wird nun, erstens, durch eine glattere Oberfläche die Kontaktfläche zur Prägemasse minimiert und, zweitens, eine formschlüssige Verbindung reduziert. Dadurch kommt es ebenfalls zu einer besseren Entformung. Die bessere und effizientere Entformung ist vor allem darauf zurück zu führen, dass die notwendige Kraft zur Entformung geringer wird. Die Rauigkeit des erfindungsgemäßen Stempelmaterials ist daher kleiner als 1µm, mit Vorzug kleiner als 100nm, mit größerem Vorzug kleiner als 10nm, mit größtem Vorzug kleiner als 1nm. Die offenbarten Rauheitswerte gelten für die mittlere Rauheit und/oder die quadratische Rauheit und/oder die gemittelte Rautiefe. Die Messung erfolgt dabei über einen Flächenabschnitt von ca. 2µm × 2µm.

In einer ganz besonderen Ausführungsform ist das erfindungsgemäße Stempelmaterial elektrisch leitfähig. Dadurch wird mit Vorzug die elektrostatische Aufladung verhindert oder zumindest vermindert. Noch bevorzugter kann das elektrisch leitfähige, erfindungsgemäße Stempelmaterial geerdet werden, sodass eine, an seiner Oberfläche entstehende, Aufladung abgeführt wird. Durch die elektrisch neutrale Oberfläche wird die Anziehung, im Besonderen die elektrostatische Anziehung, von Partikeln erschwert bzw. vollständig eliminiert und erhöht damit die Sauberkeit des Stempels über längere Zeit. Die Erdung kontaktiert das erfindungsgemäße Stempelmaterial, und damit den Stempel, mit Vorzug am Rand. Die elektrische Leitfähigkeit des Stempelmaterials kann entweder durch eine gezielt verwendete chemische Struktur erzeugt werden, die auf Grund ihrer molekularen Eigenschaft bereits eine Leitfähigkeit von Elektronen zulässt oder durch die Hinzugabe mindestens einer weiteren Komponente, welche das nicht leitfähige Stempelmaterial leitfähig macht. Besonders bevorzugt ist dabei die Verwendung von Mikro und/oder Nanopartikeln, Nanodrähten insbesondere Karbonnanoröhrchen, Graphen, Graphit etc. Die beigesetzten Mikro- und/oder Nanopartikel können mit besonderem Vorzug auch zum Heizen des Stempels verwendet werden, sofern die Aushärtung der Prägemasse thermisch und nicht, wie eigentlich bevorzugt, mittels UV Licht geschieht. Eine derartige Erwärmung durch Mikro- und/oder Nanopartikel wurde in der Patentschrift EP 2286981B1 offenbart. Die zitierte Patentschrift verweist allerdings darauf, dass die Mikro- und/oder Nanopartikel sich in der Prägemasse befinden. In der vorliegenden Anmeldung würden die Mikro- und/oder Nanopartikel sich im erfindungsgemäßen Stempelmaterial befinden, um eine direkte Erwärmung des Stempels und nicht der Prägemasse zu erzielen. Die Erwärmung der Prägemasse erfolgt dann indirekt über den Stempel. Wie in der Patentschrift EP 2286981B1 wäre es denkbar, die Mikro- und/oder Nanopartikel mittels eines magnetischen Wechselfeldes zu erwärmen, sofern die Mikro- und/oder Nanopartikel sensitiv für das Magnetfeld sind, daher magnetisch sind.

Unter Hydrophilität versteht man die hohe Wechselwirkungsfähigkeit der Oberfläche eines Stoffes mit Wasser. Hydrophile Oberflächen sind vorwiegend polar und interagieren mit den permanenten Dipolen der Moleküle von Fluiden, bevorzugt mit Wasser, entsprechend gut. Die Hydrophilität einer Oberfläche wird mit Hilfe eines Kontaktwinkelmessgeräts quantifiziert. Hydrophile Oberflächen besitzen dabei sehr geringe Kontaktwinkel. Muss die erfindungsgemäße Beschichtung eine hydrophile Oberfläche besitzen, um möglichst einfach von der Prägemasse entformt werden zu können, dann sollen erfindungsgemäß folgende Wertebereiche gelten: Eine hydrophile Oberfläche besitzt einen Kontaktwinkel kleiner als 90°, mit Vorzug kleiner als 60°, mit größerem Vorzug kleiner als 40°, mit noch größerem Vorzug kleiner als 20°, mit allergrößtem Vorzug von weniger als 10°.

Unter Hydrophobie versteht man entsprechend die geringe Wechselwirkungsfähigkeit der Oberfläche eines Stoffes mit Wasser. Hydrophobe Oberflächen sind vorwiegend unpolar und interagieren kaum mit den permanenten Dipolen der Moleküle von Fluiden. Weist die erfindungsgemäße Beschichtung in einer Ausführungsform der Erfindung eine hydrophobe Oberfläche auf, um möglichst einfach von der Prägemasse entfernt werden zu können, dann sollen erfindungsgemäß folgende Wertebereiche gelten: Eine hydrophobe Oberfläche besitzt einen Kontaktwinkel größer als 90°, mit Vorzug größer als 100°, mit größerem Vorzug größer als 120°, mit noch größerem Vorzug größer als 140°, mit allergrößtem Vorzug größer als 160°.Obwohl man mit Hilfe der Hydrophilität bzw. Hydrophobizität das Verhalten einer Oberfläche in Bezug auf Wasser charakterisiert, ist jedem Fachmann klar, dass die Adhäsionseigenschaften zwischen unterschiedlichen Materialien direkt vermessen werden müssten um exakte Aussagen über deren gegenseitiges Verhalten zu erlangen. Die Charakterisierung der Adhäsionseigenschaften einer Oberfläche in Bezug auf Wasser gibt allerdings bereits einen sehr groben Einblick in das Adhäsionsverhalten. Bei der Charakterisierung der Adhäsionseigenschaft zwischen einem Stempelmaterial und einer Prägemasse wird das Kontaktwinkelmessverfahren erfindungsgemäß bevorzugt nicht mit Wasser, sondern direkt mit einem Tropfen der Prägemasse durchgeführt, der direkt auf den Stempel abgeschieden wird.

Der erfindungsgemäße Stempel ist ein Imprintstempel zur Verwendung in der Imprinttechnologie. Der Stempel ist als Weichstempel zum Imprinten von Substraten ausgebildet. Durch das erfindungsgemäße Stempelmaterial wird die Entformung des Stempels von der Prägemasse ohne Beeinträchtigung und/oder (teilweiser) Zerstörung der Strukturen ermöglicht, indem der Stempel eine geringe Adhäsion gegenüber der Prägemasse hat. Die Adhäsionsfähigkeit zwischen zwei Oberflächen lässt sich am besten durch eine Energie pro Einheitsfläche, also eine Energieflächendichte, beschreiben. Darunter versteht man die Energie die notwendig ist, um zwei miteinander verbundene Oberflächen entlang der Einheitsfläche wieder voneinander zu trennen. Die Adhäsion zwischen Prägemasse und Strukturstempel ist dabei kleiner als 2.5 J/m², mit Vorzug kleiner als 1 J/m², mit größerem Vorzug kleiner als 0.1 J/m², mit noch größerem Vorzug kleiner als 0.01 J/m², mit größtem Vorzug kleiner als 0.001 J/m², mit allergrößtem Vorzug kleiner als 0.0001 J/m², am bevorzugtesten kleiner als 0.00001 J/m². Die Entformung ist dadurch leichter, schneller, und effizienter und kostengünstiger möglich als mit einem Stempel , der nicht das erfindungsgemäße Stempelmaterial verwendet. Kostengünstiger ist sie vor allem dadurch, dass durch die erhöhte Entformungsgeschwindigkeit die Anzahl der Prägeschritte pro Zeiteinheit erhöht werden kann. Außerdem wird die Standzeit des Stempels drastisch erhöht, so dass auch hierdurch die Herstellungskosten reduziert werden. Mit Vorzug wird ein Stempelmaterial verwendet, dessen Dichtigkeit so groß ist, dass ein Aufschwellen des Weichstempels durch das erfindungsgemäße Strukturmaterial verhindert wird, da keine Prägemasse in den Weichstempel eindringen kann.

Entsprechend wird eine Verzerrung der Stempelstruktur weitestgehend vermieden.

Das Stempelmaterial besitzt vorzugsweise eine Viskosität zwischen 1 und 2500 mPas, mit Vorzug zwischen 10 und 2500 mPas, mit größerem Vorzug zwischen 100 und 2500 mPas, mit größtem Vorzug zwischen 150 und 2500 mPas.

Weiterhin wird die Belichtungszeit der Prägemasse durch das Stempelmaterial des Stempels reduziert werden, soweit die Aufnahme von Prägematerial durch das erfindungsgemäße Stempelmaterial blockiert oder zumindest reduziert wird. Dies ist vor allem notwendig, wenn die Prägemasse durch den Strukturstempel belichtet wird. Die erfindungsgemäße Prägemasse ist damit mit Vorzug überwiegend transparent für die verwendete elektromagnetische Strahlung. Da die meisten Prägemassen mit UV Licht gehärtet werden, ist das erfindungsgemäße Stempelmaterial mit Vorzug transparent für UV Licht. Das erfindungsgemäße Stempelmaterial ist insbesondere transparent in einem Wellenlängenbereich zwischen 5000nm und 10nm, mit Vorzug zwischen 1000nm und 100nm, mit größerem Vorzug zwischen 700nm und 200nm, mit größtem Vorzug zwischen 500nm und 300nm.

Das erfindungsgemäße Stempelmaterial, die Stempelstrukturen und/oder der Strukturstempel selbst bestehen insbesondere zumindest überwiegend, vorzugsweise vollständig, aus mindestens einem der folgenden Materialien:
∘ Silikone,
   ▪ Vinylfunktionale polymere
      - Vinylterminierte Polydimethylsiloxane, insbesondere CAS: 68083-12-2
      - Vinylterminierte Diphenylsiloxane-Dimethylsiloxan Copolymere, insbesondere CAS: 68951-96-2
      - Vinylterminierte Polyphenylmethylsiloxane, insbesondere CAS: 225927-21-9
      - Vinylphenylmethylterminierte Vinylphenylsiloxane-Phenylmethylsiloxan Copolymer, insbesonder20CAS: 8027-82-1
      - Vinylterminierte Trifluoropropylmethylsiloxane-Dimethylsiloxan Copolymer, insbesondere CAS: 68951-98-4
      - Vinylmethylsiloxane-Dimethylsiloxane Copolymer, Trimethlysiloxy terminiert, insbesondere CAS: 67762-94-1
      - Vinylmethylsiloxan - Dimethylsiloxan Copolymer, Silanol teminiert, insbesondere CAS 67923-19-7
      - Vinylmethylsiloxan.Dimethylsiloxan Copolymer, Vinyl terminiert, insbesondere CAS: 68083-18-1
      - Vinylgummi
      - Vinyl Q Harzdispersionen, insbesondere230CAS: 68584-83-8
      - Vinylmethylsiloxan Homopolymere, insbesondere CAS: 68037-87-6
      - Vinyl T-Struktur Polymere, insbesondere CAS: 126681-51-9
      - Monovinyl funktionalisiertes Polydimethylsiloxan symmetrisch oder asymmetrisch, insbesondere CAS: 689252-00-1
      - Vinylmethylsiloxan Terpolymere, insbesondere CAS: 597543-32-3
      - Vinylmethoxysiloxan Homopolymer, insbesondere CAS: 131298-48-1
      - Vinylethoxysiloxan Hompolymer, insbesondere CAS: 29434-25-1
      - Vinylethoxysiloxan-Propylethoxysiloxan Copolymer
   ▪ Hydridfunktionale Polymere
      • Hydridterminierte Polydimethylsiloxane, insbesondere CAS: 70900-21-9
      • Polyphenylmethylsiloxan, Hydrid terminiert
      • Methylhydrosiloxan-Dimethylsiloxan Copolymer, Trimethylsiloxy terminiert, inbseondere CAS: 68037-59-2
      • Methylhydrosiloxan-Dimethylsiloxan Copolymer, Hydrid terminiert, insbesondere CAS: 69013-23-6
      • Polymethylhydrosiloxan, Trimethylsiloxy terminiert, insbesondere CAS: 63148-57-2
      • Polyethylhydrosiloxan, Triethylsiloxy terminiert, insbesondere CAS: 24979-95-1
      • Polyphenyl-Dimethylhydrosiloxysiloxan, Hydrid teminiert
      • Methylhydrosiloxan-Phenylmethylsiloxan Copolymer, Hydrid terminiert, insbesondere CAS: 115487-49-5
      • Methylhydrosiloxan-Octylmethylsiloxan Copolymer und Terpolymer, insbesondere CAS: 68554-69-8
      • Hydrid Q Harz, insbesondere CAS: 68988-57-8
   ▪ Silanolfunktionale Polymere
      - Silanolterminierte Polydimethylsiloxan, insbesondere CAS: 70131-67-8
      - Silanolterminiertes Diphenylsiloxan - Dimethylsiloxan Copolymer, insbesondere CAS 68951-93-9 und/oder CAS: 68083-14-7
      - Silanolterminiertes Polydiphenylsiloxan, insbesondere CAS: 63148-59-4
      - Silanolterminiertes Polytrifluoropropylmethylsiloxan, insbesondere CAS: 68607-77-2
      - Silanol-Trimethylsilyl modifiziertes Q Harz, insbesondere CAS: 56275-01-5
   ▪ Aminofunktionalisierte Silikone
      - Aminopropylterminiertes Polydimethylsiloxan, insbesondere CAS: 106214-84-0
      - N-Ethylaminoisobutylterminiertes Polydimethylsiloxan, insbeaondere CAS: 254891-17-3
      - Aminopropylmethylsiloxan - Dimethylsiloxan Copolymer, insbesondere CAS: 99363-37-8
      - Aminoethylaminopropylmethylsiloxan - Dimethylsiloxan Copolymer insbesonder CAS 71750-79-3
      - Aminoethylaminoisobutylmethylsiloxan - Dimethylsiloxan Copolymer, insbesondere CAS: 106842-44-8
      - Aminoethylaminopropylmethoxysiloxan-Dimethylsiloxan Copolymer, insbesondere CAS: 67923-07-3
   ▪ Gehinderte Aminfunkationalisierte Siloxane (engl..: hindered amine functional siloxanes)
      - Tetramethylpiperidinyloxypropylmethylsiloxan-Dimethylsiloxan Copolymer, insbesondere CAS: 182635-99-0
   ▪ Epoxyfunktionalisierte Silikone
      - Epoxypropoxypropylterminierte Polydimethylsiloxane, insbesondere CAS: 102782-97-8
      - Epoxypropoxypropylmethylsiloxan-Dimethylsiloxan Copolymer, insbesondere CAS: 68440-71-7
      - Epoxypropoxypropylterminierte Polyphenylmethylsiloxan, insbesondere20CAS: 102782-98-9
      - Epoxypropoxypropyldimethoxysilylterminierte Polydimethylsiloxane, insbesondere CAS: 188958-73-8
      - Tris(Glycidoxypropyldimethylsiloxy)Phenylsilan, insbesondere CAS: 90393-83-2
      - Mono-(2,3-Epoxy)-Propyletherterminierte Polydimethylsiloxane (bevorzugte Ausführungsform), insbesonder CAS: 127947-26-6
      - Epoxycyclohexylethylmethylsiloxan-Dimethylsiloxan Copolymer, insbesonder CAS: 67762-95-2
      - (2-3% Epoxycyclohexylethylmethylsiloxan)(10-15% Methoxypolyalkyleneoxymethylsiloxan)-Dimethylsiloxan Terpolymer, insbesonder CAS: 69669-36-9
   ▪ Cycloaliphatische Epoxysilane und Silikone
      - Epoxycyclohexylethylmethylsiloxan)-Dimethylsiloxan Copolymer, insbesondere CAS: 67762-95-2
      - (2-3% Epoxycyclohexylethylmethylsiloxan)(10-15% MEthoxypolyalkyleneoxymethylSiloxan)-Dimethylsilxoan Terpolymer, insbesondere CAS: 69669-36-9
      - Epoxycyclohexylethylterminerte Polydimethylsiloxane, insbesondere CAS: 102782-98-9
   ▪ Carbinolfunktionalisierte Silikone
      - Carbinolhydroxylterminierte Polydimethylsiloxane, insbesondere CAS: 156327-07-0, CAS: 104780-66-7, CAS: 68937-54-2, CAS: 161755-53-9, CAS: 120359-07-1
      - Bis(Hydroxyethyl)Amin)terminierte Polydimethylsiloxane
      - Carbinolfunktionaliserte MEthylsiloxan-Dimethylsiloxan Copolymere, insbesondere CAS: 68937-54-2, CAS: 68957-00-6, CAS: 200443-93-2
      - Monocarbinolterminierte Polydimethylsiloxane, insbesondere CAS: 207308-30-3
      - Monodicarbinolterminierte Polydimethylsiloxane, insbesondere CAS: 218131-11-4
   ▪ Methacrylate und Acrylat-funktionalisierte Siloxane
      - Methacryloxypropylterminierte Polydimethylsiloxane, insbesondere CAS: 58130-03-3
      - (3-Acryloxy-2-hydroxypropoxypropyl)terminierte Polydimethylsiloxane, insbesondere CAS: 128754-61-0
      - Acryloxyterminierte Ethyleneoxide-Dimethylsiloxane-Ethyleneoxide ABA Block Copoly,ere, insbesondere CAS: 117440-21-9
      - Methacryloxypropylterminierte verzweigte Polydimethylsiloxane, insbesondere CAS: 80722-63-0
      - Methacryloxypropylmethylsiloxan-Dimethylsiloxan Copolymer, insbesondere: CAS: 104780-61-2
      - Acryloxypropylmethylsiloxan-Dimethylsiloxan Copolymer, insbesondere CAS: 158061-40-6
      - (3-Acryloxy-2-Hydroxypropoxypropyl)Methylsiloxan-Dimethylsiloxan Copolymer
      - Methacryloxypropyl T-strukturierte Siloxane, insbesondere CAS: 67923-18-6
      - Acryloxypropyl T-strukturierte Siloxane
   ▪ Polyhedrales oligomerisches Silsesquioxan (POSS)
   ▪ Tetraethylorthosilicat (TEOS)
   ▪ Poly(organo)siloxane

Bevorzugt besteht das Stempelmaterial aus einem Epoxy-Silikon und/oder einem Akrylat-Silikon. Bei der chemischen Grundstruktur des erfindungsgemäßen Stempelmaterials handelt es sich daher um ein Polydimethylsiloxan, bei dem in regelmäßigen oder unregelmäßigen Abständen Methylgruppen durch Epoxidgruppen und/oder Akrylatgruppen ersetzt wurden. Diese chemischen Gruppen erlauben vorzugsweise die Härtung des erfindungsgemäßen Stempelmaterials mittels UV Licht. Zum Starten des UV-Härtungsprozesses können dem erfindungsgemäßen Stempelmaterial entsprechende Radikal- und/oder Kationenstarter hinzugegeben werden.

Des Weiteren ist es denkbar, den Stempel, insbesondere die Stempelstrukturen, aus einer Materialkombination der oben genannten Materialien herzustellen. Denkbar ist auch die Verwendung eines Stempels und einer Rückplatte (engl.: backplane) in Serie, wobei Stempel und Rückplatte im allgemeinen aus unterschiedlichen Materialien bestehen. Die Verwendung mehrerer unterschiedlicher Materialien führt dazu, dass die daraus hergestellten einzelnen oder zusammengesetzten Stempel als Hybridstempel bezeichnet werden. Die Rückplatte kann dabei als Versteifung des Stempels dienen. Denkbar sind allerdings auch Rückplatten die extrem flexibel sind und nur als Träger für den Stempel dienen. Die Rückplatte hat dann insbesondere eine Dicke, die geringer ist als 2000µm, mit Vorzug geringer als 1000µm, mit größerem Vorzug geringer als 500µm, mit größtem Vorzug geringer als 100µm.

In einer besonders bevorzugten Ausführungsform wird der Stempel mit einer Antihaftschicht beschichtet, um zusätzlich eine Verringerung der Adhäsion zwischen erfindungsgemäßen Stempelmaterial und Prägemasse zu erreichen. Mit Vorzug handelt es sich bei der Antihaftschicht um organische Moleküle mit entsprechend niedrigen Adhäsionseigenschaften zur Prägemasse. Sollte der Stempel bereits impermeabel für die Moleküle der Prägemasse sein, so wie es beispielsweise für metallische, keramische oder gläserne Stempel meist der Fall ist, kann auf eine erfindungsgemäße Beschichtung als Diffusionsbarriere verzichtet werden und der Stempel kann direkt mit einer Antihaftschicht, in diesem Fall als erfindungsgemäße Beschichtung, beschichtet werden. Damit ergibt sich zumindest ein positiver Effekt bezüglich der Entformungseigenschaft auf Grund von Adhäsion. Eine derartige Beschichtung wurde bereits in der Patentschrift PCT/EP2013/062922 erwähnt, auf die insofern verwiesen wird.

Das erfindungsgemäße Stempelmaterial ist bei UV-Aushärtung des Prägematerials mit Vorzug zumindest teilweise transparent für den Wellenlängenbereich der elektromagnetischen Strahlung, welche das Prägematerial vernetzt. Die optische Transparenz ist dabei größer als 0%, mit Vorzug größer als 20%, mit größerem Vorzug größer als 50%, mit größtem Vorzug größer als 80%, mit allergrößtem Vorzug größer als 95%. Der Wellenlängenbereich für die optische Transparenz liegt insbesondere zwischen 100nm und 1000nm, vorzugsweise zwischen 150nm und 500nm, mit größerem Vorzug zwischen 200nm und 400nm, mit größtem Vorzug zwischen 250nm und 350nm.

Ist die Prägemasse thermisch auszuhärten, besitzt der Stempel, insbesondere die erfindungsgemäße Beschichtung eine möglichst hohe Wärmeleitfähigkeit. Die Wärmeleitfähigkeit ist dabei größer als 0.1 W/(m^{∗}K), mit Vorzug größer als 1 W/(m^{∗}K), mit Vorzug größer als 10 W/(m^{∗}K), mit größtem Vorzug größer als 100 W/(m^{∗}K), mit allergrößtem Vorzug größer als 1000 W/(m*K).

Der Strukturstempel mit Beschichtung ist insbesondere temperaturstabil ausgebildet. Der Strukturstempel kann insbesondere bei Temperaturen größer 25°C, mit Vorzug größer 100°C, mit größerem Vorzug größer als 250°C, mit größtem Vorzug größer als 500°C, mit allergrößtem Vorzug größer als 750°C verwendet werden.

Der E-Modul charakterisiert die Elastizität eines Werkstoffes. Bevorzugt sind möglichst kleine E-Moduli, um den Strukturstempel verformbar zu halten und damit leichter von der Prägemasse trennen zu können. Bei der Elastizität handelt es sich vorwiegend um eine Entropieelastizität. Der E-Modul ist daher erfindungsgemäß kleiner als 10000 MPa, mit Vorzug kleiner als 1000 MPa, mit größerem Vorzug kleiner als 100 MPa, mit größtem Vorzug zwischen 1 und 50 MPa, mit allergrößtem Vorzug zwischen 1 und 20 MPa.

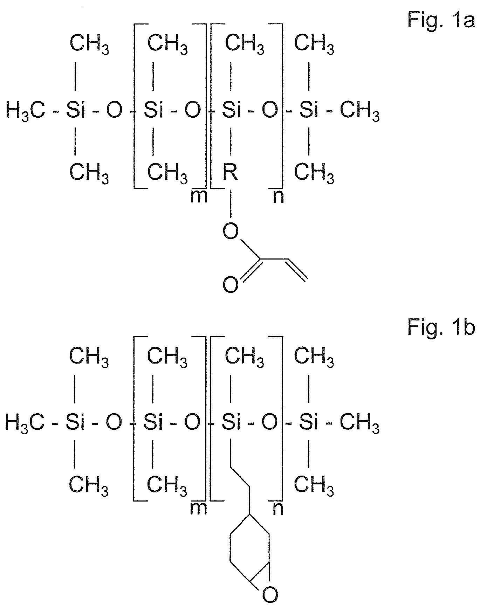

- Figur 1a: zeigt die chemische Strukturformel eines bevorzugten Akrylatsilikons und
- Figur 1b: zeigt die chemische Strukturformel eines bevorzugten Epoxysilikons.

## Patentansprüche

1. System bestehend aus einer Prägemasse und einem Imprintstempel mit einer Stempelstruktur zur Herstellung einer Struktur in der Prägemasse, wobei die Stempelstruktur zumindest teilweise aus einem Silikon als Stempelmaterial gebildet ist, wobei der Imprintstempel verformbar ausgebildet ist, wobei der Imprintstempel ein E-Modul kleiner als 10.000 MPa aufweist, **dadurch gekennzeichnet, dass** die Rauigkeit der Oberfläche des Imprintstempels kleiner als 1 µm beträgt, wobei die Rauigkeitswerte für die mittlere Rauheit und/oder die quadratische Rauheit und/oder die gemittelte Rautiefe gelten, wobei die Messung der Rauigkeit über einen Flächenabschnitt von ca. 2 µm × 2 µm erfolgt, wobei die Adhäsion zwischen der Prägemasse und dem Imprintstempel kleiner als 2,5 J/m² ist.

2. System nach Anspruch 1, wobei das Stempelmaterial Epoxy und/oder Acrylgruppen aufweist.

3. System nach Anspruch 1 oder 2, wobei das Stempelmaterial aus einem oder mehreren der nachfolgend genannten Materialen gebildet ist:
- Akrylat- oder Epoxysilikon,
- Polyhedrales oligomerisches Silsesquioxan (POSS),
- Tetraethylorthosilicat (TEOS) und/oder
- Poly(organo)siloxane.

4. System nach einem der vorhergehenden Ansprüche, bei dem das Stempelmaterial durch UV-Strahlung oder durch thermische Bestrahlung ausgehärtet oder aushärtbar ist.

5. System nach einem der vorhergehenden Ansprüche, bei dem das Stempelmaterial in einem Wellenlängenbereich zwischen 5000nm und 10nm, mit Vorzug zwischen 1000nm und 100nm, mit größerem Vorzug zwischen 700nm und 200nm, mit größtem Vorzug zwischen 500nm und 400nm, transparent ist.

6. Verfahren zur Ausbildung eines Systems bestehend aus einer Prägemasse und einem Imprintstempel mit einer Stempelstruktur zur Herstellung einer Struktur in der Prägemasse, wobei die Stempelstruktur zumindest teilweise aus einem Silikon als Stempelmaterial gebildet wird, wobei der Imprintstempel verformbar ausgebildet ist, wobei der Imprintstempel ein E-Modul kleiner als 10.000 MPa aufweist, **dadurch gekennzeichnet, dass** die Rauigkeit der Oberfläche des Imprintstempels kleiner als 1 µm beträgt, wobei die Rauigkeitswerte für die mittlere Rauheit und/oder die quadratische Rauheit und/oder die gemittelte Rautiefe gelten, wobei die Messung der Rauigkeit über einen Flächenabschnitt von ca. 2 µm × 2 µm erfolgt, wobei die Adhäsion zwischen der Prägemasse und dem Imprintstempel kleiner als 2,5 J/m² ist.

7. Verfahren nach Anspruch 6, wobei das Stempelmaterial der Stempelstruktur durch UV-Bestrahlung oder durch thermische Bestrahlung ausgehärtet wird.

## Claims

1. A system comprising an embossing compound and an imprint stamp with a stamp structure for producing a structure in the embossing compound, wherein the stamp structure is formed at least partially from a silicone as a stamp material, wherein the imprint stamp is constituted deformable, wherein the imprint stamp has a modulus of elasticity less than 10,000 MPa, **characterised in that** the roughness of the surface of the imprint stamp amounts to less than 1 µm, wherein the roughness values apply to the average roughness and/or the root-mean-squared roughness and/or the averaged roughness, wherein the measurement of the roughness takes place over a surface area of approximately 2 µm × 2 µm, wherein the adhesion between the embossing compound and the imprint stamp is less than 2.5 J/m².

2. The system according to claim 1, wherein the stamp material comprises epoxy and/or acrylic groups.

3. The system according to claim 1 or 2, wherein the stamp material is formed from one or more of the undermentioned materials:
- Acrylate or epoxy silicone,
- polyhedral oligomeric silsesquioxane (POSS),
- tetraethyl orthosilicate (TEOS) and/or
- poly(organo)siloxane.

4. The system according to any one of the preceding claims, wherein the stamp material is cured or can be cured by UV radiation or by thermal radiation.

5. The system according to any one of the preceding claims, wherein the stamp material is transparent in a wavelength range between 5000 nm and 10 nm, preferably between 1000 nm and 100 nm, more preferably between 700 nm and 200 nm, most preferably between 500 nm and 400 nm.

6. A method for the formation of a system comprising an embossing compound and an imprint stamp with a stamp structure for producing a structure in the embossing compound, wherein the stamp structure is formed at least partially from a silicone as a stamp material, wherein the imprint stamp is constituted deformable, wherein the imprint stamp has a modulus of elasticity less than 10,000 MPa, **characterised in that** the roughness of the surface of the imprint stamp amounts to less than 1 µm, wherein the roughness values apply to the average roughness and/or the root-mean-squared roughness and/or the averaged roughness, wherein the measurement of the roughness takes place over a surface area of approximately 2 µm × 2 µm, wherein the adhesion between the embossing compound and the imprint stamp is less than 2.5 J/m².

7. The method according to claim 6, wherein the stamp material of the stamp structure is cured by UV radiation or by thermal radiation.

## Revendications

1. Système composé d'une masse à gaufrer et d'un tampon d'impression doté d'une structure de tamponnage pour la création d'une structure dans la masse à gaufrer, la structure de tamponnage étant composée du moins partiellement d'un silicone servant de matériau de tampon, le tampon d'impression étant réalisé de manière à être déformable, le tampon d'impression présentant un module E inférieur à 10 000 MPa, **caractérisé en ce que** la rugosité de la surface du tampon d'impression est inférieure à 1 µm, les valeurs de rugosité étant valables pour la rugosité moyenne et/ou la rugosité quadratique et/ou la profondeur de rugosité moyenne, la mesure de la rugosité ayant lieu sur une section de surface d'environ 2 µm × 2 µm, l'adhérence entre la masse à gaufrer et le tampon d'impression étant inférieure à 2,5 J/m².

2. Système selon la revendication 1, dans lequel le matériau du tampon présente de l'époxy et/ou des groupes acryliques.

3. Système selon la revendication 1 ou 2, dans lequel le matériau de tampon est composé d'un ou plusieurs des matériaux cités ci-après :
- silicone d'acrylate ou d'époxy,
- silsesquioxane oligomère polyédrique (POSS),
- tétraéthylorthosilicate (TEOS) et/ou
- poly(organo)siloxanes.

4. Système selon une des revendications précédentes, dans lequel le matériau de tampon est durci ou durcissable par rayonnement UV ou par rayonnement thermique.

5. Système selon une des revendications précédentes, dans lequel le matériau de tampon est transparent dans une plage de longueur d'onde de 5000 nm à 10 nm, de préférence 1000 nm à 100 nm, très préférentiellement de 700 nm à 200 nm, le plus préférentiellement de 500 nm à 400 nm.

6. Procédé de réalisation d'un système composé d'une masse à gaufrer et d'un tampon d'impression doté d'une structure de tamponnage pour la création d'une structure dans la masse à gaufrer, la structure de tamponnage étant composée du moins partiellement d'un silicone servant de matériau de tampon, le tampon d'impression étant réalisé de manière à être déformable, le tampon d'impression présentant un module E inférieur à 10 000 MPa, **caractérisé en ce que** la rugosité de la surface du tampon d'impression est inférieure à 1 µm, les valeurs de rugosité étant valables pour la rugosité moyenne et/ou la rugosité quadratique et/ou la profondeur de rugosité moyenne, la mesure de la rugosité ayant lieu sur une section de surface d'environ 2 µm × 2 µm, l'adhérence entre la masse à gaufrer et le tampon d'impression étant inférieure à 2,5 J/m².

7. Procédé selon la revendication 6, dans lequel le matériau de tampon de la structure de tamponnage est durci par rayonnement UV ou par rayonnement thermique.
